# EUROPEAN PATENT SPECIFICATION

(11) **EP 4 252 348 B1**
(45) Date of publication and mention of the grant of the patent: **26.06.2024**
(21) Application number: 21823867.3
(22) Date of filing: 01.12.2021
(51) Int. Cl.: H02S 20/30

(54) **CAR BODY PANEL INCLUDING A SOLAR CELL ARRANGEMENT AND METHOD FOR PRODUCING SAME**
KAROSSERIEPANEEL MIT SOLARZELLENANORDNUNG UND VERFAHREN ZU DESSEN HERSTELLUNG
PANNEAU DE CARROSSERIE DE VOITURE COMPRENANT UN AGENCEMENT DE CELLULES SOLAIRES ET SON PROCÉDÉ DE PRODUCTION

(30) Priority: 11.12.2020 GB 202019566
(43) Date of publication of application: 04.10.2023
(73) Proprietor: Sono Motors GmbH, 80935 München (DE)
(72) Inventor: KAPP, Camillo, 80992 München (DE); ZURMÜHL, Georg, 80796 München (DE)
(74) Representative: Qip Patentanwälte Dr. Kuehn & Partner mbB
(86) International application number: PCT/EP2021/083775
(87) International publication number: WO 2022/122507

(56) References cited:
- JP-A- H11 321 332
- KR-A- 20180 020 002
- US-A1- 2020 313 012
- US-B2- 10 293 867

## Description

### FIELD OF THE INVENTION

The present invention relates to a car body panel including a solar cell arrangement and to a method for fabricating such car body panel.

### BACKGROUND OF THE INVENTION

In the following, the term "photovoltaic" may be abbreviated by "PV". PV cells may also be referred to as solar cells.

Approaches have been presented in which PV cells are provided at a body of a car for generating electricity to be supplied to the car. Such electricity may be used for example for charging batteries of an electric car.

For example, it has been proposed e.g. in an earlier patent application WO 2019/020718 A1 of the present applicant to provide solar cells in a body panel of a vehicle. Therein, a PV module shall be placed on top of such body panel or, preferably, the PV module shall be integrated into the body panel. Specifically, one or more solar cells may be arranged in an air tight and water tight manner in a recess provided in a carrier structure of a car body panel.

In an alternative approach for manufacturing PV modules, it has been proposed by the present applicant in an earlier patent application PCT/EP2020/056972 to integrate a solar cell arrangement into a moulded layer formed by injection moulding. Therein, the solar cell arrangement is interposed between polymeric foils, thereby forming a so-called photovoltaic label which may be securely handled and in which the solar cells are for example protected against excessive mechanical stress during an injection moulding procedure.

In both prior art approaches, the car body panel including the solar cell arrangement may be regarded as a photovoltaic module having a non-planar shape. A body panel of a vehicle including an integrated PV module may be referred to herein as PV integrated car body panel.

Possible features and characteristics of such approaches of car body panels and approaches for fabricating a car body panel including a photovoltaic module have been described by the applicant in the above mentioned patent applications as well as in further prior patent applications such as two patent applications filed in the United Kingdom with the application numbers 2009642.6 (title: "Method for fabricating a photovoltaic module including laser cutting of a photovoltaic label") and 2009653.3 (title: "Method for fabricating a curved photovoltaic module including adapted positioning of photovoltaic cells"). Features and characteristics of such approaches may also apply to the car body panel and the fabrication method described herein and the content of the earlier patent applications shall be incorporated in its entirety herein by reference.

It may be an object to provide a car body panel in which a solar cell arrangement is integrated and which fulfils both, very high functional requirements as well as very high aesthetic requirements. Furthermore, it may be an object to provide a method for fabricating a car body panel in which a solar cell arrangement is integrated and which enables a relatively simple fabrication procedure, high fabrication yield and/or low fabrication costs while providing a fabrication result as a highly functional, reliable and aesthetic PV-integrated car body panel.

US 2020/313012 A1 discloses a solar cell panel and a method for manufacturing the same.

### SUMMARY OF THE INVENTION AND OF EMBODIMENTS

Such object may be achieved with a car body panel and a method for fabricating a car body panel as defined in the independent claims. Preferred embodiments are defined in the dependent claims as well as in the subsequent specification.

According to a first aspect of the invention, a car body panel comprising an integrated solar cell arrangement is proposed. The car body panel comprises a photovoltaic label, a carrier substrate and a cover foil. The photovoltaic label comprises a front side polymeric stabilisation foil, a front side polymeric lamination foil, a rear side polymeric lamination foil and, optionally, a rear side polymeric stabilisation foil as well as the solar cell arrangement interposed between both lamination foils. The carrier substrate comprises a recess area in which an outer surface of the carrier substrate is depressed in comparison to an outer surface in an area adjacent to the recess area. The photovoltaic label is accommodated within the recess area. Lateral dimensions of the recess area and of the photovoltaic label are set such that a gap extends between an outer lateral circumference of the photovoltaic label and an outer lateral circumference of the recess area. The cover foil comprises an opaque area. The cover foil is arranged at an outer surface of the car body panel such that its opaque area covers the gap as well as at least part of the outer surface of the carrier substrate in the area adjacent to the recess area.

According to a second aspect of the invention, a method for fabricating a car body panel is proposed. The method comprises at least the following steps, preferably in the indicated order:
(i) providing a photovoltaic label, a carrier substrate and a cover foil,
   wherein the photovoltaic label comprises a front side polymeric stabilisation foil, a front side polymeric lamination foil, a rear side polymeric lamination foil and, optionally, a rear side polymeric stabilisation foil as well as a solar cell arrangement interposed between both lamination foils,
   wherein the carrier substrate comprises a recess area in which an outer surface of the carrier substrate is depressed in comparison to an outer surface in an area adjacent to the recess area, and
   wherein the cover foil comprises an opaque area;
(ii) accommodating the photovoltaic label within the recess area,
   wherein lateral dimensions of the recess area and of the photovoltaic label are set such that a gap extends between an outer lateral circumference of the photovoltaic label and an outer lateral circumference of the recess area; and
(iii) arranging the cover foil at an outer surface of the car body panel such that its opaque area covers the gap as well as at least part of the outer surface of the carrier substrate in the area adjacent to the recess area.

Ideas underlying embodiments of the present invention may be interpreted as being based, inter alia and without restricting a scope of the invention, on the following observations and recognitions.

First, some basic ideas underlying embodiments of the present invention may be briefly summarised as follows:
In the approach proposed herein, a PV integrated car body panel may be fabricated by, first, providing a photovoltaic label and a carrier substrate as separate components and, then, combining such components. Therein, the carrier substrate may have a nonplanar contour such as to form the car body panel as a part of an entire car design. For example, the car body panel may be formed as a fender, hood, roof part, door panel, hatchback, etc.

Generally, PV cells could be arranged on top of the carrier substrate forming the car body panel. However, in such approach, the PV cells would protrude beyond an outer surface of the car body panel. This would negatively affect both, the functionality as well as an aesthetics of the PV integrated car body panel. On the one hand, the PV cells would be prone to mechanical damaging as they would form the outermost part of the car body panel and would therefore have to absorb any mechanical impact acting on the car body panel. On the other hand, the protruding PV cells would degrade an optical appearance of the car body panel.

It is therefore proposed to provide the carrier substrate with a recess area. In this recess area, an outer surface of the carrier substrate is depressed with respect to laterally adjacent areas of the outer surface of the carrier substrate. The PV cells may then be accommodated within this recess area.

Furthermore, it has been found that PV cells may be beneficially handled and applied to the carrier substrate, if not each PV cell has to be handled individually but a multiplicity of PV cells is provided as a solar cell arrangement of interconnected PV cells and is integrated into a PV label. Such PV label typically comprises a rear side polymeric lamination foil and a front side polymeric lamination foil between which the solar cell arrangement is interposed such that, upon laminating both lamination foils, the solar cell arrangement is embedded in an encapsulation formed by the laminated lamination foils. Furthermore, the PV label comprises a front side polymeric stabilisation foil and, optionally, a rear side polymeric stabilisation foil. Such stabilisation foil typically has a larger thickness and/or is made from a more stable material as compared to the lamination foils.

Upon fabricating the PV integrated car body panel, the PV label may be accommodated within the recess area in the carrier substrate. A depth of the recess area may be set such that the PV label may be accommodated therein without protruding beyond an intended outer surface of the car body panel in accordance with the car design. Furthermore, lateral dimensions of the recess area may be set sufficiently large such that the entire PV label may be accommodated completely within the recess area without overlapping adjacent areas of the outer surface of the carrier substrate.

However, it has been found that lateral dimensions of the PV label and lateral dimensions of the recess area should not correspond to other precisely. For example, upon fabricating the PV label, fabrication tolerances may apply resulting in slightly varying lateral dimensions of the PV label. Furthermore, it has been observed that, generally, the PV label and its components may have different characteristics with regard to their thermal expansion as compared to the carrier substrate. Accordingly, upon temperature variations applying to the car body panel, the lateral dimensions of the PV label may vary more or less than the lateral dimensions the carrier substrate and of the recess area comprised therein. Accordingly, in order to absorb both, fabrication tolerances as well as differences in thermal expansion, it is proposed to provide the recess area in the carrier substrate with lateral dimensions relative to lateral dimensions of the PV label such that a lateral gap is generated and extends between the outer lateral circumference of the PV label and the outer lateral circumference of the recess area.

While it has accepted that such lateral gap may be necessary for technical reasons, it has been found that the presence of the lateral gap may negatively affect other technical characteristics and/or aesthetics of the PV integrated car body panel. For example, it has been found that the gap should be filled with a filler material in order to for example prevent water or dirt from entering the gap resulting in a possible deteriorating or even damaging of the PV integrated car body panel. However, it has been further observed that the filler material may suffer from deterioration over time due to for example temperature effects and/or UV radiation effects. Furthermore, the gap filled with filler material may generally negatively influence an appearance and design of the car body panel.

Accordingly, it is suggested to provide a cover foil as an additional component for the car body panel. Such cover foil may be a polymeric foil having specific characteristics such as to protect an underlying portion of the carrier substrate and/or of the photovoltaic label covered by the cover foil as well as to improve an optical appearance of the car body panel. The cover foil may be adhered to an outer surface of the carrier substrate and/or of the PV label. Accordingly, the cover foil may form an outermost portion or layer of the car body panel at least in those areas of the car body panel which are covered by the cover foil. The cover foil comprises an opaque area, i.e. an area with no substantial light transmission. Accordingly, the cover foil defines an optical appearance of the car body panel at least in those areas covered by the opaque area of the cover foil. Specifically, the cover foil shall be arranged such that its opaque area covers the gap as well as at least part of the outer surface of the carrier substrate in an area adjacent to the recess area, i.e. adjacent to the gap. The opaque area may surround a window area formed by an opening or by a transparent area of the cover foil, wherein the window area may be arranged on top of the solar cell arrangement such as to enable substantially unlimited light transmission to the solar cells. Accordingly, by using such specific cover foil and specifically locally arranging it at the outer surface of the car body panel, the opaque area of the cover foil may, on the one hand, cover and thereby optically "hide" the underlying gap and, on the other hand, mechanically protect at least partial areas of the outer surface of the car body panel such that no unintended substances may enter for example the gap.

Overall, the application of the cover foil with its opaque area may result in an improved appearance of the car body panel, particularly in a transitory area where the PV label laterally adjoins adjacent portions of the carrier substrate. Furthermore, the application of the cover foil may also provide for improved functionality and longevity of the car body panel.

Next, possible details, features and advantages of embodiments of the proposed PV integrated car body panel and of the method for fabricating such car body panel will be discussed:
The approach proposed herein is particularly suitable for a car body panel comprising multiple PV cells which are prepared based on brittle semiconductor wafers. The PV cells may be for example solar cells being fabricated based on crystalline silicon wafers. Such wafer-based Si-PV cells may generally have e.g. a high efficiency of more than 15% (i.e. e.g. between 17% and 26%) and a high reliability. Furthermore, well established industrial processes exist for their fabrication. Such PV cells typically have lateral dimensions of between 50x50 mm² and 300x300 mm², mostly between 150x150 mm² and 200x200 mm², with a square shape, a rectangular shape, a round shape, a semi-round shape or any other shape. Furthermore, such PV cells generally have a thickness of more than 50 µm, typically between 100 µm and 300 µm. Having such thickness, the PV cells are relatively rigid, i.e. they may generally not be bent into small bending radii of e.g. less than their lateral dimensions. Each PV cell comprises electric contacts. The electric contacts of neighbouring PV cells may be interconnected via electrical connections such that these PV cells may be electrically connected in series, in parallel or in any combination of series and parallel connections. The electrical connections may be provided by one or more electrically conducting ribbons and/or one or more copper solderings between two adjacent photovoltaic cells, preferably between each two adjacent photovoltaic cells of a respective string. A plurality of interconnected PV cells forms part of a solar cell arrangement, sometimes also referred to as solar cell string. The solar cell arrangement may further comprise additional components such as external contacts via which the solar cell arrangement may be connected to an external electric circuit, such external contacts sometimes being referred to as forming part of a junction box. Furthermore, the solar cell arrangement may comprise for example bypass diodes or other electric components. Additionally, one or more release loops for releasing mechanical tensions may be included in the solar cell arrangement.

The solar cell arrangement is generally comprised in an encapsulation into which the solar cells, the electrical interconnections and possibly other components are embedded. Typically, the encapsulation comprises or consists of a thermoplastic polymer such as EVA (Ethylene Vinyl Acetate). The encapsulation may be composed of a front side encapsulation foil and a rear side encapsulation foil enclosing the plurality of solar cells from opposite sides. In a lamination procedure, such front and rear side encapsulation foils may then be heated beyond a glassifying temperature of the polymeric material while being pressed against each other. Accordingly, the sticky viscous or even partially molten polymer material of both encapsulation foils may combine in regions where the foils contact each other and/or may glue to solar cells interposed between the encapsulation foils. Accordingly, upon cooling down and solidifying the polymer material, the solar cells and the polymer material may form an encapsulation.

As the solar cell arrangement in its encapsulation is generally very fragile, the solar cell arrangement including the solar cells, the electric connections and the encapsulation is reinforced by one or more stabilisation foils for forming a PV label. Preferably, a front side polymeric stabilisation foil and a rear side polymeric stabilisation foil may enclose the interposed solar cell arrangement and may form a substrate and a superstrate, respectively, prior to accommodating the PV label in the recess area of the carrier substrate. In specific embodiments as described below, the PV label may not necessarily comprise the rear side polymeric stabilisation foil. The polymeric stabilisation foils may have a thickness of typically between 500µm and 2500µm. Each of the foils may adjoin and/or cover a part or an entirety of one of opposing surfaces of all of the PV cells. The polymeric stabilisation foils may be made with various polymeric materials such as ethylene vinyl acetate (EVA), polycarbonate (PC), polyethylenterephthalat (PET), polyamide (PA), polyetheretherketone (PEEK), acrylonitrile butadiene styrene (ABS), poly(methyl methacrylate) (PMMA) or a mix of them. Particularly, a material forming the stabilisation foil may be a thermoplastic material, i.e. a material which becomes plastic or viscous upon being heated to elevated temperatures. The front and rear side polymeric stabilisation foils may enclose the interposed solar cell arrangement and, upon being joined with each other, encapsulate the solar cell arrangement. Optionally, glass fiber reinforced or carbon fiber reinforced plastics may be included between the polymeric foils.

Particularly, the front side stabilisation polymeric foil, the rear side stabilisation polymeric foil and the PV cells may be joined together by an application of heat and/or a lamination process. In other words, after having arranged e.g. the rear side polymeric stabilisation foil, the solar cell arrangement with its encapsulation and finally the front side polymeric stabilisation foil on top of each other in a lose manner, these stacked layers may be interconnected by mechanically joining with each other. Such joining may be induced for example by applying sufficient heat to the stack such that the polymeric material of the polymeric foils becomes viscous and/or sticky. Accordingly, upon such temporary application of heat, the polymeric stabilisation foils may mechanically interconnect with each other and/or with the interposed solar cell arrangement. Thus, the front and rear side polymeric stabilisation foils and the solar cell arrangement are joined in a lamination procedure. The lamination procedure may be integral with the lamination procedure used for forming the encapsulation embedding the PV cells, i.e. both the front and rear side polymeric stabilisation foils as well as the front and rear side polymeric encapsulation foils may be glassified or partially molten within a single lamination step. Alternatively, two separate lamination steps may be performed, i.e., first, the solar cell arrangement is laminated with the encapsulation foils enclosing the PV cells and, then, the PV label is laminated with the stabilisation foils enclosing the solar cell arrangement in between. As a result of such lamination procedure, the front and rear side polymeric foils and, optionally, also the PV cells are integrally joined with each other in a positive substance jointing. However, the lamination procedure may alternatively or additionally include other measures for joining the polymeric foils such as for example applying a glue or adherent at an interface between the polymeric foils and/or at an interface between one of the polymeric foils and the solar cell arrangement.

The entire PV label may have a thickness in a range of between 0.5 mm to 10 mm, typically between 1 mm to 5 mm. Lateral dimensions of the PV label may range from about 0.1 m to 2 m, typically from 0.2 m to 1 m. The PV label may be flexible and bendable and may be formed into an arbitrary contour being adapted to a shape of the intended car body panel. Therein, the solar cells comprised in the car body panel cover a substantial portion, i.e. for example more than 30%, preferably more than 50% or even more than 70%, of an outer surface of the car body panel.

The carrier substrate may be a self-supporting structure having physical characteristics such as to fulfil typical requirements of a car body panel with regard to stability, rigidity, loadability, etc. Furthermore, the carrier substrate may be shaped with a non-planar contour such as to implement a design, i.e. an optical appearance, of a car body composed of various body panels. Particularly, the carrier substrate may have lateral dimensions in a range of typically between a few centimeters up to a few meters, for example between 10 cm and 2 m. Furthermore, the carrier substrate may have a thickness such as to provide for a sufficient stability for the car body panel. For example, the thickness may range from between a few millimeters to a few centimeters, typically between 2 mm and 2 cm. Furthermore, the carrier substrate may comprise reinforcement structures such as ribs or other protruding structures in order to increase the stability of the car body panel. For example, the carrier substrate may have a shape and contour of a fender, hood, roof, hatchback, door or a similar component.

Preferably, the carrier substrate may have a non-uniform thickness. Particularly, the carrier substrate has a recess area in which its outer surface is depressed as compared to laterally adjacent outer surface areas. Such recess area may be formed by locally reducing the thickness of the carrier substrate. Specifically, a depth of the depressed area may correspond to a difference in thickness in the depressed area as compared to a thickness in a laterally adjacent non-depressed area. More generally, the depth of the depressed area corresponds to a difference of the level of the outer surface of the carrier substrate within the depressed area, on the one hand, and of the level of the outer surface of the carrier substrate in a laterally adjacent non-depressed area, on the other hand. The depth of the depressed area may be set such as to generally correspond to a thickness of the PV label. Tolerances of the depth of the depressed area and/or of the thickness of the PV label may be small, for example smaller than half of or preferably smaller than 10 % of the thickness of the PV label or smaller than 1 mm, preferably smaller than 0.2 mm. Accordingly, the PV label may be fitted into the depressed area without substantially protruding beyond the outer surface of the carrier substrate in the non-depressed area. Specifically, while both, the depressed area and the non-depressed area may form curved surfaces, the PV label may be fitted into the depressed area such that an outer surface of the resulting car body panel including the PV label accommodated within the depressed area is smooth and represents an intended design of the final car body panel. The recess area may extend along significant or even major portions of the outer surface of the carrier substrate.

According to an embodiment, the carrier substrate may comprise or consist of a polymer material. Furthermore, the carrier substrate may optionally be reinforced with metal and/or glass particles.

Particularly, the polymer material may be a thermoplastic or thermosetting material. For example, the polymeric material may be or comprise polyamide (PA), polypropylene (PP), acrylonitrile butadiene styrene (ABS), poly(methyl methacrylate) (PMMA) or another plastic material having similar mechanical stability and rigidity.

The polymer material may optionally be reinforced with metal and/or glass particles. Such metal and/or glass particles may be added to a powder or melt of the polymer material. The metal and/or glass particles may have dimensions in a range from a few microns to a few millimetres, typically a range from 5 µm to 0.5 mm. A content of metal and/or glass particles in the polymer material matrix may be in a range from a few volumetric percent to some tens of volumetric percent, e.g. between 5 vol-% and 60 vol-%. The metal particles may consist of one of various metals such as aluminum, iron, copper, nickel, chromium, etc. and mixtures or alloys of such metals. For example, the carrier substrate may be made with a mixture of polyamide material reinforced with aluminum particles, such mixture being also known as alumide. The mixture of polymer material and metal and/or glass particles may provide for beneficial characteristics of the final car body panel such as high mechanical stability, high thermal resistivity, high quality optical appearance similar to components with a metallic surface, etc.

While car body panels are conventionally made with metal sheets, forming a car body panel based on a carrier substrate mainly comprising or consisting of a polymeric material may provide for various advantages such as light weight, high scratch resistance, low material costs, low manufacturing costs, etc. Furthermore, particularly for a PV integrated car body panel, a carrier substrate of polymeric material may be easily formed with a relatively complex geometry comprising for example the recess area.

According to an embodiment, the carrier substrate may be formed by 3D printing, injection molding or thermoforming.

All these manufacturing methods are well suited for preparing a carrier substrate for a car body panel with a complex, nonplanar geometry by processing a polymeric material optionally including metal and/or glass particles. The methods allow for generating high-quality products while keeping manufacturing costs low.

For example, 3D printing methods such as selective laser melting (SLM), selective laser sintering (SLS) or other additive manufacturing techniques may be applied for preparing a product by locally heating a polymeric powder and/or a metallic powder and/or a mixture of both, thereby adhering powder particles to each other due to localised melting or sintering processes. Products having a complex geometry may be generated using 3D printing methods. Particularly, 3D printing methods are known for their variability and may be applied particularly beneficially in prototype manufacturing or low volume manufacturing. High quality car body panels may e.g. be fabricated based on 3D printed carrier substrates made for example with alumide material. Injection molding methods, in which liquefied polymeric material, optionally including metal and/or glass particles, is injected into a mold, are well-suited for a high volume manufacturing of polymeric products such as carrier substrates for car body panels at relatively low costs. Same applies to thermoforming methods, in which polymeric material, optionally including metal and/or glass particles, is permanently deformed upon application of elevated temperatures and/or pressure.

Independent of which manufacturing method is used for preparing the carrier substrate, the carrier substrates are to be formed with the recess area for accommodating the PV label. Therein, lateral dimensions of the recess area are set depending on lateral dimensions of the PV label. Specifically, such lateral dimensions are set such that the gap extending between the lateral circumference of the PV label and a circumference or outer edge of the recess area is sufficiently wide such as to fulfil specific technical requirements.

For example, according to an embodiment, the gap may have a width of at least 1mm, preferably at least 2 mm at least 3 mm, at least 5 mm or at least 8 mm, while the width typically remaining smaller than 30 mm, preferably smaller than 15 mm.

Particularly, the width of the gap may be set such that differences in lateral thermal expansion between the PV label, on the one side, and the carrier substrate, on the other side, may be tolerated without outer edges of the PV label coming into direct abutment to an edge of the carrier substrate at a circumference of the recess area. For example, in a typical temperature range to be assumed during car operation, such differences in lateral thermal expansion are found to result in differences of lateral dimensions of the PV label in comparison to lateral dimensions of the recess area of up to several millimeters. Furthermore, the width of the gap may be set such that, additionally, also variations in lateral dimensions of the PV label and/or of the recess area in the carrier substrate resulting for example from fabrication tolerances may be tolerated. Such fabrication tolerances may occur for example upon laser cutting the PV label in order to define outer dimensions of the PV label and/or upon 3D printing, injection molding or thermoforming the carrier substrate. Typically, such fabrication tolerances may be in a range of a few to several tenths of millimeters, e.g. between 0.1 mm and 2 mm.

According to an embodiment, the gap may at least partly be filled with a putty.

A putty may be a material which may be processed in a liquid or viscous state and which may subsequently solidify. Accordingly, upon fabricating the car body panel, the putty may be introduced into the gap and upon solidification fill at least part of the gap. Preferably, the gap is completely filled with the putty such as to generate a smooth and/or flush transition between the outer surface of the PV label, on the one side of the putty-filled gap, and the outer surface of the carrier substrate, on the other side of the gap. For example, the putty may be a space filling adhesive such as to serve as a repair, sealant and/or filler. Therein, the putty should have a sufficient elasticity such as to repair, seal and/or fill the gap even when dimensions of the gap are varying e.g. due to thermal expansion effects and/or application of mechanical loads. For example, the putty may be a polyurethane glue. The material of the putty may have a same, similar or different coefficient of thermal expansion (CTE) of other materials comprised in the body panel, particularly as a material of the carrier substrate and/or of the PV label. Furthermore, the putty may have good processability, good adhesion to the PV label (typically polycarbonate (PC)) and/or the carrier substrate (typically polyamide (PA) or PC), good elasticity and/or good viscoelastic.

Generally, the gap could also be filled with other materials such as for example silicone. However, it has been found that using silicone as a gap filler material may result in vast and highly visible shrinkage and expansion upon thermal variations, for example when exposed to the sun, due to silicone having a high coefficient of thermal expansion. In contrast hereto, filling the gap with the putty may avoid such deficiencies and may result in a durable interconnection between PV label and the carrier substrate by the putty in the gap.

Upon the gap being filled and, optionally, being levelled, the cover foil may be applied to the semi-finished car body panel. Therein, the cover foil may be arranged at the outer surface of the car body panel such that the opaque area of the cover foil at least covers the gap and a portion of the outer surface of the carrier substrate in an area adjacent to the gap. Preferably, the cover foil covers the entire exposed outer surface the carrier substrate, i.e. all areas which are not covered by the PV label. Furthermore, preferably, the cover foil also overlaps and covers a portion of the PV label at the circumference of the PV label. In other words, the cover foil may partly overlap, e.g. with an offset of between 1 mm and 10 mm, the PV label in an area near to its outer circumference. In other words, the cover foil may e.g. cover the laterally outermost few millimetres of the PV label, i.e. a portion of the PV label in which only the stabilisation and encapsulation foils but no PV cells are present.

Accordingly, in the finished car body panel, the cover foil "hides" and mechanically protects the gap and the putty comprised therein. Furthermore, the cover foil covering an adjacent area of the carrier substrate and preferably also covering an adjacent area of the PV label forms a smooth and aesthetic transition between both areas. Particularly, the opaque area of the cover foil may be adapted such that its optical appearance corresponds to an appearance of the PV label. Accordingly, the entire car body panel may have a uniform appearance with both areas, i.e. the area covered by the opaque area of the cover foil as well as the area of the PV label not being covered by the opaque area of the cover foil, having a similar appearance, i.e. having a similar colour, similar reflectivity, etc. For example, the opaque area of the cover foil may be black, dark grey or dark blue.

According to an embodiment, the cover foil is a self-adhesive foil.

In other words, a rear side of the cover foil may be provided with an adhesive layer or glue. The adhesive or glue may cover an entire rear side surface of the cover foil or may be applied locally, e.g. in dots or stripes. Accordingly, the cover foil may be easily adhered to the areas of the car body panel to be covered by the cover foil. Furthermore, the self-adhesive foil may have high scratch resistance, preferably a scratch resistance being sufficiently high such as to mechanically protect the underlying components of the car body panel against being scratched. Furthermore, the cover foil may have self-healing properties. For example, the cover foil may be adapted such that damages such as scratches may be healed, i.e. may disappear and/or lose their visibility, upon certain repair measures being applied, e.g. upon heat being applied to the cover foil. Furthermore, the cover foil may be specifically configured for a use on vehicles and their body panels. The cover foil may be easily replaceable, have a long lifetime of for example at least several years, preferably more than 10 years, may have a good durability and/or may be easily applied.

According to an embodiment, the car body panel may further comprise a coating layer forming an outermost layer at the outer surface of the car body panel at least in an area on top of the photovoltaic label and, preferably, on top of the gap.

In other words, such coating layer may cover the PV label as well as at least partial areas of the cover layer being laterally adjacent to the PV label. Preferably, the coating layer is highly transparent, i.e. may have a transparency of more than 80% or preferably more than 95 % or more than 98 %, particularly with regard to light wavelengths at which the PV cells are sensitive (e.g for silicon solar cells typically between approximately 350nm and 1100nm). The coating layer may have a matte finish. For example, the coating layer may be an acrylic paint. The coating layer may be sprayed, painted, rolled or in other ways applied onto the outer surface of the car body panel. Alternatively or additionally, the coating layer may be a transparent foil. The coating layer may smoothen a transition between the PV label and the cover layer. Furthermore, the coating layer may homogenize optical characteristics such as glossiness in different areas of the car body panel. Additionally, the coating layer may protect the underlying PV label and/or other parts of the car body panel against physical and/or chemical influences.

Particularly, according to a specific embodiment, the coating layer may have a higher scratch resistance than the cover foil.

Accordingly, the cover layer may protect the underlying PV label and, optionally, the underlying cover foil against being scratched. For example, the scratch resistance of a material or of a layer may be tested conducting a so-called pencil tests. Therein, a pencil with a sharp needle is applied with a defined force on the test sample and is moved along a surface of the sample. Scratches occurring in the sample upon such procedure may then be analysed e.g. with regard to a depth and/or width and/or with regards to a visibility of the scratches. Pencil tests conducted on the coating layer may then be compared to pencil test conducted on the cover foil and should show better scratch resistance. For example, any tear-off, i.e. material removal, of an underlying material or layer or of paintwork may not be permissible, whereas any trace of the indentation caused by loading the substrate may be permissible.

According to an embodiment, the cover foil may furthermore comprise a transparent area and the cover foil may be arranged such that its transparent area is positioned on top of the solar cell arrangement of the photovoltaic label.

In other words, the cover foil may not only comprise the opaque area but may additionally comprise a transparent area. The transparent area may form a window which may be positioned above the solar cell arrangement such as to allow substantially unlimited light transmission.

In principle, the cover foil could exclusively comprise the opaque area for covering the gap and adjacent portions of the outer surface of the carrier substrate and, optionally, of the PV label. In such case, the opaque area of the cover foil could form a ring which encloses an opening. The opening could be arranged on top of the solar cell arrangement. However, in such embodiment, the cover foil would have a complex design with the opening in the centre. Handling such cover foil might be difficult. Furthermore, in such embodiment, the surface the PV label would not be covered by the cover foil such that additional mechanical protection may be required for example by applying the above mentioned additional scratch resistant coating layer.

Accordingly, it is suggested to implement the cover foil such as to additionally comprise the transparent area. Such cover foil may consist of a continuous layer which, in the opaque area, is configured to absorb incident light whereas, in the transparent area, is configured to transmit incident light. Such continuous cover foil may be easily handled. The cover foil may be adhered to the outer surface of the carrier substrate and PV label such that the transparent area allows unrestricted light transmission to the solar cell arrangement whereas the opaque area hides the gap and covers adjacent portions of the carrier substrate and an overlap portion at the circumference of the photovoltaic label.

According to an embodiment, the photovoltaic label may be attached with its rear side to a front side surface of the carrier substrate within the recess area. Accordingly, the method for fabricating the car body panel proposed herein may comprise a step of attaching the PV label with its rear side to the front side of the carrier substrate within the recess area.

In other words, the PV label may be mechanically held within the recess area of the carrier substrate in which it has been accommodated by attaching its rear side to the underlying opposing surface of the carrier substrate. Accordingly, the PV label may be securely fixed at the carrier substrate. Such attaching may be established in various manners.

For example, according to an embodiment, the outer surface of the carrier substrate in the recess area may be non-planar and, upon attaching the photovoltaic label to the carrier substrate, the photovoltaic label may be deformed such as to conform to the non-planar outer surface of the carrier substrate in the recess area.

In other words, while the PV label and particularly the solar cells comprised therein may originally have a planar shape, such planar shape may be permanently deformed such as to correspond to the nonplanar shape of the outer surface of the carrier substrate in the recess area. The deformation may be induced upon attaching the PV label to the carrier substrate.

For example, the carrier substrate and the PV label may be arranged in an assembly jig in which both components are pressed against each other. Therein, a pressing tool may be used which allows to press the PV label into a configuration in which it conforms with the nonplanar shape of the outer surface of the carrier substrate within the recess area. For example, the pressing tool may have a shape which is substantially complementary to the nonplanar shape of the recess area's surface. Accordingly, using the assembly jig and/or the pressing tool, the PV label may be pressed against the outer surface of the carrier substrate with a homogenous pressure distribution such that the PV label may be carefully deformed into the intended shape at the car body panel and excessive local forces e.g. resulting in damaging of the fragile solar cells may be avoided.

According to an embodiment of the car body panel, the rear side polymeric lamination foil or the rear side polymeric stabilisation foil of the photovoltaic label may form a positive substance jointing for attaching the photovoltaic label to the front side surface of the carrier substrate. For an embodiment of the production method proposed herein, this means that the photovoltaic label may be laminated onto the carrier substrate such that the rear side polymeric lamination foil or, if present, the rear side polymeric stabilisation foil of the photovoltaic label forms a positive substance jointing for attaching the photovoltaic label to the front side surface of the carrier substrate.

In other words, for attaching the PV label to the carrier substrate, the PV label may be laminated onto the front side surface of the carrier substrate in the recess area. For such lamination procedure, the polymeric encapsulation foils and/or the polymeric stabilisation foils being in contact with the front surface of the carrier substrate may be heated beyond their glassifying temperature and may simultaneously be pressed against the front surface of the carrier substrate. Accordingly, upon subsequent cooling down and solidification, such polymeric foils may establish a positive substance jointing with the carrier substrate for attaching the PV label within the recess area. Such lamination procedure may establish a very strong, uniform and/or reliable fixation of the PV label to the carrier substrate. The PV label can be uniformly pressed against the outer surface of the carrier substrate and may thus be arranged at a very precise level with regard to such outer surface. Particularly, no separate application of a glue or adhesive is required. Furthermore, the lamination procedure may be beneficially included in an overall fabrication procedure.

According to an alternative embodiment, the carrier substrate may comprise at least one depression at its front side surface within the recess area and the depression may be filled with a glue for attaching the photovoltaic label to the front side surface of the carrier substrate. The photovoltaic label may then directly abut to the front side surface of the carrier substrate in partial areas of the recess area laterally adjacent to the depression. Accordingly, when the carrier substrate comprises at least one depression at its front side surface within the recess area, the fabrication method according to an embodiment may further comprise a step of filling the depression with a glue for attaching the photovoltaic label to the front side surface of the carrier substrate. Therein, upon being accommodated within the recess area, the photovoltaic label directly abuts to the front side surface of the carrier substrate in partial areas of the recess area laterally adjacent to the depression.

Expressed differently, in the recess area of the carrier substrate, one or more depressions may be provided. At such depression, the front surface of the carrier substrate is at a lower level than in adjacent non-depressed parts of the recess area. The depression may have any shape. For example, the depression may be elongate. In other words, the depression may be formed by a groove. Such grooves may be linear or curved. The depression may extend throughout various portions of the recess area. For example, the depression(s) may be provided such that each location throughout the recess area is spaced apart from at least one of the depressions by less than an acceptable maximum distance, such maximum distance being e.g. smaller than 40 cm or smaller than 20 cm. For example, the depression may be ring-like and/or may extend in close neighborhood to the circumference of the recess area. The depression may comprise multiple partial depressions. The partial depressions maybe locally separated from each other. The depression may have a depth which is significantly smaller than a thickness of the carrier substrate in the recess area. For example, the depth of the depression may be in a range of 0.1 mm to 5 mm, preferably 0.5 mm to 3 mm. A lateral width of the depression may be substantially smaller than lateral dimensions of the recess area, preferably substantially smaller than 20% or even smaller than 5% of the lateral dimensions of the recess area. For example, the width may be in a range of 0.2 cm to 20 cm, preferably 0.5 cm to 5 cm.

Upon fabricating the car body panel, the depression may be filled partly or completely with a glue. The glue should be able to adhere to both, the surface of the carrier substrate as well as the surface of the rear side polymeric foil of the PV label. Subsequently, the PV label may be accommodated within the recess area and may be pressed against the front surface of the carrier substrate. Therein, on the one hand, the PV label comes into contact with the glue provided within the depression. On the other hand, the PV label comes into contact with and is supported by the front side surface of the carrier substrate in partial areas of the recess area laterally adjacent to the depression. While the first contact with the glue results in adhering the PV label to the carrier substrate, the second contact with the partial areas of the carrier substrate beside the depression may enable precisely arranging the PV label at an intended level within the recess area of the carrier substrate. In other words, due to the fact that the glue is not provided as a continuous layer along the entire front surface of the recess area but is only provided in the depression, the partial areas next to the depression which are free from any glue may define a very precise level at which the PV label may be abutted. Accordingly, the PV label may be precisely levelled within the recess area.

According to an embodiment, the carrier substrate may comprise at least one through hole within the recess area, the through hole connecting a front side of the carrier substrate within the recess area with a rear side of the carrier substrate.

Such through-hole may establish a fluid connection between the front side and the rear side of the carrier substrate. Therein, one end of the through-hole may be ending at a position adjacent to a rear side of the PV label whereas the other end may be emptying to a rear side of the carrier substrate. Accordingly, in case there is any cavity enclosed between the PV label and the carrier substrate, this cavity may be vented through the through-hole. The through hole may have a diameter of e.g. between 0.5 mm and 5 cm, preferable between 1 mm and 1 cm.

An alternative embodiment of the fabrication method may comprise additional steps of:
- providing a lamination bag comprising a front side bag foil and a rear side bag foil enclosing an inner volume;
- introducing the carrier substrate with the photovoltaic label being accommodated in the recess area into the inner volume of the lamination bag, and
- laminating the front side bag foil and the rear side bag foil onto opposite outer surfaces of the carrier substrate, respectively, such as to enclose the carrier substrate with the photovoltaic label being accommodated in the recess area from both opposing sides between the bag foils of the lamination bag.

In such approach, the lamination bag may be specifically configured and used for a lamination procedure in which the carrier substrate with the PV label accommodated in its recess area is enclosed between the front and rear side bag foils of the lamination bag. Then, the entire arrangement may be heated to elevated temperatures and simultaneously compressed such that the front and rear side bag foils are laminated to each of opposing outer surfaces of the carrier substrate and the PV label, respectively. For example, a vacuum may be applied to the inner volume of the lamination bag during the lamination procedure. Thereby, the bag foils of the lamination bag may form an outer layer enclosing the entire car body panel from all sides.

As the bag foils are laminated to the carrier substrate accommodating the PV label in its recess area, the PV label is then securely held within the recess area. Optionally, the lamination procedure for eliminating the lamination bag may be adapted such that also polymeric foils comprised in the PV label are laminated to the carrier substrate, thereby further improving a mechanical connection between the PV label and the carrier substrate.

Optionally, according to a further specified embodiment, the cover foil may be formed by a portion of the front side bag foil of the lamination bag.

In other words, instead of providing the cover foil as a separate layer, the function of the cover foil may be established by a portion of the front side bag foil of the lamination bag. Accordingly, this front side bag foil may comprise the opaque area for recovering the gap as well as the transparent area for forming the window area on top of the solar cell arrangement.

It shall be noted that possible features and advantages of embodiments of the invention are described herein with respect to a car body panel and to a method for fabrication a car body panel. One skilled in the art will recognize that the features may be suitably transferred from one embodiment to another and features may be modified, adapted, combined and/or replaced, etc. in order to come to further embodiments of the invention.

### BRIEF DESCRIPTION OF THE DRAWINGS

In the following, advantageous embodiments of the invention will be described with reference to the enclosed drawings. However, neither the drawings nor the description shall be interpreted as limiting the invention.
Fig. 1 shows a cross sectional view through a car body panel according to an embodiment of the present invention.
Figs. 2 shows a top view onto a car body panel according to an embodiment of the present invention.
Fig. 3 shows a cross sectional view through a car body panel and visualizes processing step of a fabrication method according to an embodiment of the present invention.

The figures are only schematic and not to scale. Same reference signs refer to same or similar features.

### DESCRIPTION OF ADVANTAGEOUS EMBODIMENTS

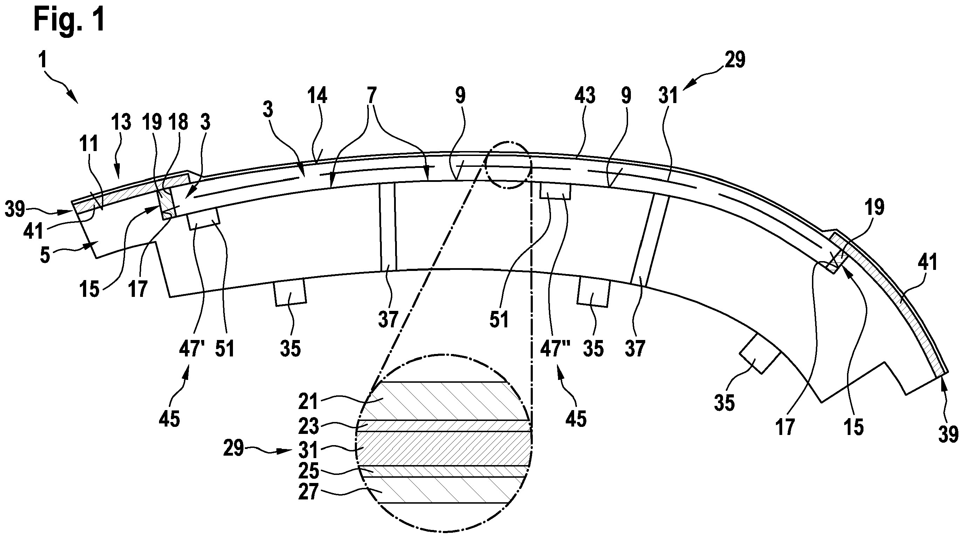

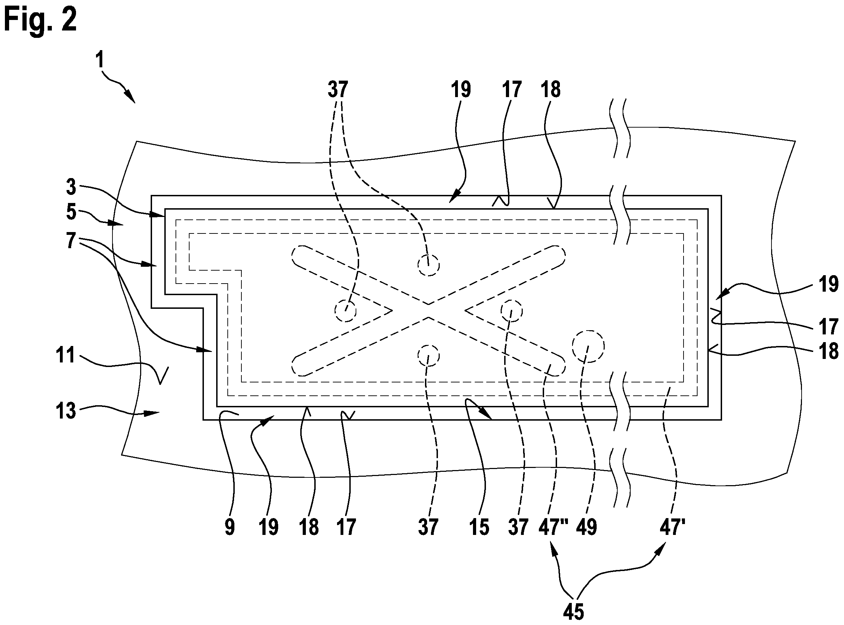

Fig. 1 and Fig. 2 show a cross-sectional view and a top view, respectively, of a portion of car body panel 1 according to an embodiment of the present invention. The car body panel 1 may have a curved, i.e. nonplanar, shape, particularly a curved outer surface and may be for example a fender panel, door panel, hood panel, roof panel, hatch panel, etc.

The car body panel 1 comprises integrated photovoltaics. Specifically, the car body panel 1 comprises a PV label 3 which is applied to a carrier substrate 5.

As shown in the enlarged view in Fig. 1, the PV label 3 comprises a front side polymeric stabilisation foil 21, a front side polymeric lamination foil 23, a rear side polymeric lamination foil 25 and a rear side polymeric stabilisation foil 27. A solar cell arrangement 29 is interposed between the front and rear side polymeric lamination foils 23, 25. The solar cell arrangement 29 comprises multiple solar cells 31 arranged in a matrix arrangement. The solar cells 31 may be highly efficient wafer-based silicon solar cells. The solar cells 31 are interconnected via electrical interconnectors (not shown) in order to form serial and/or parallel electrical connections to thereby form strings of several interconnected solar cells 31. The various polymeric foils 21, 23, 25, 27 and the interposed solar cell arrangement 29 are laminated with each other thereby forming the PV label 3 in which the solar cells 31 are tightly enclosed in an encapsulation formed by the front and rear side laminated lamination foils 23, 25 and in which the solar cells 31 are mechanically held and protected by the reinforcing front and rear side stabilisation foils 21, 27. The front and rear side lamination foils 23, 25 are typically made with EVA and may have a typical thickness of about 0.2 mm. The front and rear side stabilisation foils 21, 27 may be made with the same or another polymeric material, for example with a polycarbonate material (sometimes also referred to as Lexan^{®}) and may have a larger thickness than the lamination foils 23, 25, for example a thickness of typically between 0.3 mm and 1 mm.

The carrier substrate 5 comprises a recess area 7. An outer surface 9 of the carrier substrate 5 in the recess area 7 is depressed in comparison to an outer surface 11 in an area 13 adjacent to the recess area 7. Accordingly, a step 15 typically having a height of a few millimetres is formed at a lateral circumference 17 of the recess area 7. The height of such step 15 may at least roughly correspond to a thickness of the PV label 3.

The carrier substrate 5 may generally have a nonplanar shape as intended for the design of the resulting car body panel 1. For example, the outer surfaces 9, 11 and/or opposing inner surfaces may be curved in one or two dimensions and curvature radii may vary along the outer surfaces 9, 11. Such carrier substrate 3 may be made for example using 3D printing, injection moulding or thermoforming. The carrier substrate 3 may comprise or consist of a polymer material such as for example polyamide, optionally reinforced with metal and/or glass particles such as for example aluminium particles. Accordingly, the carrier substrate 3 may provide for a sufficient stability and rigidity as well as for a high quality appearance for the car body panel 1. In order to further increase a stiffness of the car body panel 1, ribs 35 may be provided on a rear side of the carrier substrate 5. Furthermore, ventilation through holes 37 may be provided within the recess area 7, such through holes 37 interconnecting a front side of the carrier substrate 5 within the recess area 7 with a rear side of the carrier substrate 5 in order to enable a ventilation between both sides. Furthermore, the carrier substrate 5 may comprise one or more electrical connection through-holes 49 through which electrical connections may extend in order to enable electrically connecting the solar cell arrangement 29 to an electrical consumer outside of the car body panel 1.

The PV label 3 is accommodated within the recess area 7. Therein, lateral dimensions of the recess area 7 are set slightly larger than lateral dimensions of the PV label 3. The PV label 3 is centrally positioned within the recess area 7 such that a gap 19 extends between the lateral circumference 17 of the recess area 7 and a lateral circumference 18 of the PV label 3. Such gap 19 has a typical width in a range of 6 mm ± 3 mm.

The gap 19 is partly filled or completely filled with a putty 33. Preferably, the putty 33 completely fills the gap 19 such as to form a flush transition between an outer surface 14 of the PV label 3 and the outer surface 11 of the carrier substrate 5 in the area 13 adjacent to the recess area 7.

The car body panel 1 further comprises a cover foil 39. The cover foil 39 at least comprises an opaque area 41 in which the cover foil 39 has high light absorbance and may have for example a same or similar optical appearance, i.e. a same or similar colour and/or glossiness, as the solar cell arrangement 29 comprised in the PV label 3. The cover foil 39 is arranged such that its opaque area 41 covers the gap 19 as well as at least part of the outer surface 11 of the carrier substrate 5 in the area 13 adjacent to the recess area 7. Furthermore, the cover foil 39 preferably laterally slightly overlaps an outer circumferential area of the PV label 3. The cover foil 39 may be self-adhesive such that it may be easily adhered to the front side outer surfaces 11, 14 of the carrier substrate 5 and of the PV label 3.

Finally, the car body panel 1 further comprises a coating layer 43. Such coating layer 43 forms an outermost layer at the outer surface of the car body panel 1 at least in an area on top of the PV label 3 and on top of the gap 19. In the embodiment shown in Fig. 1, the coating layer 43 covers the entire outer surface of the car body panel 1. For example, such coating layer 43 may be sprayed, rolled or painted onto such outer surface. Such coating layer 43 should be highly transparent and may provide for improved mechanical and/or chemical protection, particularly for additional scratch resistance.

The car body panel 1 may be fabricated in various manners. With reference to Figs. 1 and 2, a first embodiment of a fabrication method shall be described.

First, a photovoltaic label 3, a carrier substrate 5 and a cover foil 39 are provided. Each of these components may be prefabricated and may have the characteristics and dimensions indicated above.

Furthermore, the carrier substrate 5 may be provided with one or more depressions 45. Such depressions 45 may for example be formed as elongate grooves 47. In the exemplary embodiment shown in Fig. 2, one groove 47' extends in a ring-like configuration along the or close to the outer circumference 17 of the recess area 5. Other grooves 47" may be arranged closer to the centre of the recess area 7.

Before accommodating the PV label 3 within the recess area 7 of the carrier substrate 5, a glue 51 may be filled into the depressions 45. The glue 51 may completely fill each depression 45 and may even slightly protrude beyond the depression 45. Then, the PV label 3 is inserted into the recess area 7 in a centred manner such that the gap 19 extends along its circumference 18. Therein, as the glue 51 is exclusively provided within the depressions 45, the PV label 3 may directly abut with its rear side to the front side surface 9 of the carrier substrate 5 in partial areas of the recess area 7 adjacent to the depressions 45. In other words, most of the rear side of the PV label 3 may be positioned in direct contact with the front side surface 9 of the carrier substrate 5, thereby resulting in a very precise levelling of the PV label 3 within the recess area 7 such that the PV label 3 may extend in conformity along the non-planar surface 9 of the carrier substrate 5. For example, an assembly jig (not shown) may be used for pressing the PV label 3 uniformly against the front side surface of the carrier substrate 3 in the recess area 7.

Upon the PV label 3 being centrally positioned within the recess area 7 and adhered to the carrier substrate 5, the gap 19 may be filled with the putty 33. Optionally, after curing, the putty 33 may be levelled and/or sanded to generate a smooth and/or flush transition between adjacent outer surfaces 11, 14 of the carrier substrate 5, on the one side, and of the PV label 3, on the other side.

Subsequently, the cover foil 39 may be applied to the outer surface of the car body panel 1. For example, a black matte vinyl foil may be applied with its self-adhesive back side to such outer surface. The foil may be continuous and may be applied to the entire outer surface of the car body panel 1 including the outer surface of the PV label 3. Subsequently, the foil may be cutted according to a desired cutline such that the cover foil 39 is covering the outer surface 11 of the carrier substrate 5 in the area 13 adjacent to the recess area 7 as well as is covering the outer surface of the putty 33 in the gap 19 and slightly overlapping the PV label 3 with an offset of e.g. about 5 mm along the circumference 18. Accordingly, the cover foil 39 comprises an opening forming a window in an area on top of the PV label 3, such window enabling unrestricted incidence of light to the solar cell arrangement 29.

Finally, the coating layer 43 may be applied on top of the outer surface of the car body panel 1. For example, a transparent acrylic paint may be applied to the outer surface 14 of the PV label 3 as well as to the outer surface of the cover foil 39 surrounding the PV label 3.

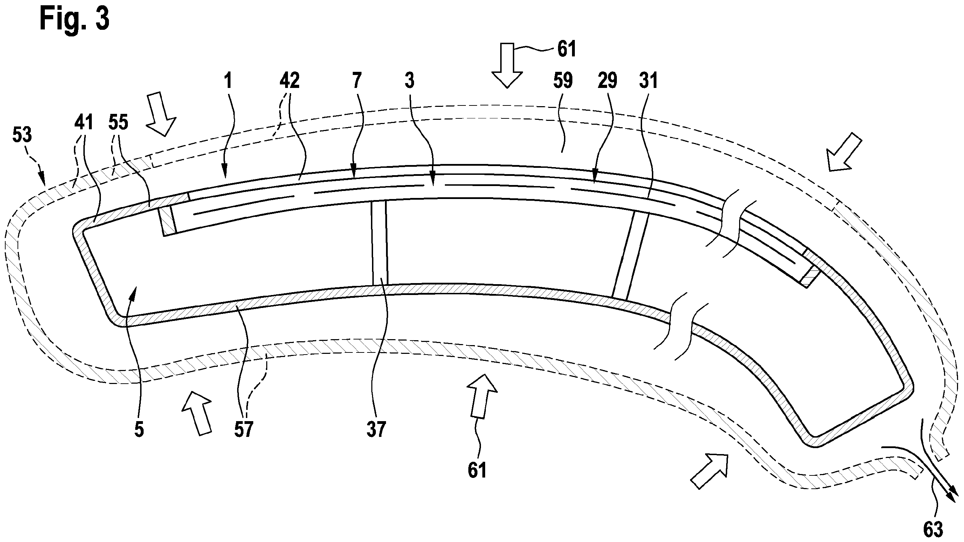

In an alternative approach to be explained with reference to Fig. 3, the PV integrated car body panel 1 may be fabricated using a lamination procedure for fixing the PV label 3 to the carrier substrate 5. Accordingly, in such approach, providing depressions 45 and applying a glue 51 may be dispensable.

For example, the PV label 3 may be attached to the carrier substrate 5 in a 3D lamination procedure. In such lamination procedure, the rear side polymeric lamination foil 25 and/or the rear side polymeric stabilisation foil 27 of the PV label 3 may be heated to elevated temperatures such as to glassify and to then form a positive substance jointing with the front side surface of the carrier substrate 5 upon subsequent solidification. During such lamination procedure, uniform pressure may be applied to the PV label 3 such that the PV label 3 including its originally planar solar cells 31 is deformed such as to conform with the nonplanar outer surface 9 of the carrier substrate 5.

Optionally, during the lamination procedure, also the cover foil 39 may be simultaneously be applied, wherein the cover foil 39 may be laminated to form a positive substance jointing with the underlying surface of the carrier substrate 5 and, optionally, with the underlying surface of the PV label 3. Therein, in a beneficial approach, the cover foil 3 may not only be provided with the opaque area 41 but also with a transparent area 42 which may then form a transparent window area on top of the solar cell arrangement 29.

In a further specified embodiment, a lamination bag 53 may be provided for further integrating the entire fabrication procedure. Such lamination bag 53 comprises a front side bag foil 55 and a rear side bag foil 57 enclosing an inner volume 59. The carrier substrate 5 with the PV label 3 accommodated within its recess area 7 may be introduced into the inner volume 59 of the lamination bag 53. Subsequently, the lamination bag 53 and, optionally, the entire arrangement enclosed in its inner volume 59 may be heated beyond a glassifying temperature of the polymer material of the lamination bag 53. Simultaneously, uniform compression pressure may be applied to the lamination bag 53 from all sides, as indicated with the arrows 61 in Fig. 3. For example, a vacuum 63 may be applied to the inner volume 59 of the lamination bag 53 such that atmospheric pressure may generate the compression pressure 61. Accordingly, as visualized in Fig. 3, as a result of the 3D lamination procedure in such approach, the 3D lamination may be used for fixing the PV label 3 to the carrier substrate 5 while applying any glue may be dispensable. Simultaneously with the lamination process, the PV label 3 may be deformed in an adequate nonplanar configuration. Thereby, form stability of the parts may be increased and no assembly jig may be necessary any more. Furthermore, using for example a custom-made foil as a lamination bag 53, such custom-made foil having integrated therein the opaque area 41 as well as the transparent area 42, a separate step for applying the cover foil 39 may be dispensable as such cover foil 39 may already form part of the front side bag foil 55. Overall, several process steps may be integrated in such embodiment of the fabrication method.

Finally, it should be noted that the term "comprising" does not exclude other elements or steps and the "a" or "an" does not exclude a plurality. Also elements described in association with different embodiments may be combined. It should also be noted that reference signs in the claims should not be construed as limiting the scope of the claims.

### List of reference numerals:

- 1: car body panel
- 3: PV label
- 5: carrier substrate
- 7: recess area
- 9: outer front side surface of the carrier substrate in the recess area
- 11: outer front side surface of the carrier substrate in the area adjacent to the recess area
- 13: area adjacent to the recess area
- 14: outer surface of the PV label
- 15: step
- 17: lateral circumference of the recess area
- 18: lateral circumference of the PV label
- 19: gap
- 21: front side polymeric stabilisation foil
- 23: front side polymeric lamination foil
- 25: rear side polymeric lamination foil
- 27: the rear side polymeric stabilisation foil
- 29: solar cell arrangement
- 31: solar cells
- 33: putty
- 35: ribs
- 37: through-holes
- 39: cover foil
- 41: opaque area
- 42: transparent area
- 43: coating layer
- 45: depression
- 47: grooves
- 49: electrical connection through-hole
- 51: glue
- 53: lamination bag
- 55: front side bag foil
- 57: rear side bag foil
- 59: inner volume
- 61: arrow indicating compression pressure
- 63: vacuum

## Claims

1. Car body panel (1) comprising:
a photovoltaic label (3), and
a carrier substrate (5),
wherein the photovoltaic label (3) comprises a front side polymeric stabilisation foil (21), a front side polymeric lamination foil (23), a rear side polymeric lamination foil (25) and, optionally, a rear side polymeric stabilisation foil (27), and wherein the photovoltaic label (3) further comprises a solar cell arrangement (29) interposed between both lamination foils (23, 25), wherein the carrier substrate (5) comprises a recess area (7) in which an outer surface (9) of the carrier substrate (5) is depressed in comparison to an outer surface (11) in an area (13) adjacent to the recess area (7),
wherein the photovoltaic label (3) is accommodated within the recess area (7), wherein lateral dimensions of the recess area (7) and of the photovoltaic label (3) are set such that a gap (19) extends between an outer lateral circumference (18) of the photovoltaic label (3) and an outer lateral circumference (17) of the recess area (7),
**characterized in that**
the car body panel further comprises a cover foil (39),
wherein the cover foil (39) comprises an opaque area (41), and
wherein the cover foil (39) is arranged at an outer surface of the car body panel (1) such that its opaque area (41) covers the gap (19) as well as at least part of the outer surface (11) of the carrier substrate (5) in the area (13) adjacent to the recess area (7).

2. Car body panel according to claim 1,
wherein the gap (19) has a width of at least 1 mm and/or
wherein the gap (19) is at least partly filled with a putty (33), and/or
wherein the cover foil (39) is a self-adhesive foil.

3. Car body panel according to one of the preceding claims, further comprising a coating layer (43) forming an outermost layer at the outer surface of the car body panel (1) at least in an area on top of the photovoltaic label (3) and, preferably, on top of the gap (19), and
wherein, optionally, the coating layer (43) has a higher scratch resistance than the cover foil (39).

4. Car body panel according to one of the preceding claims, wherein the cover foil (39) furthermore comprises a transparent area (42) and wherein the cover foil (39) is arranged such that its transparent area (42) is positioned on top of the solar cell arrangement (29) of the photovoltaic label (3).

5. Car body panel according to one of the preceding claims, wherein the photovoltaic label (3) is attached with its rear side to a front side surface of the carrier substrate (5) within the recess area (7).

6. Car body panel according to claim 5, wherein one of the rear side polymeric lamination foil (25) and the rear side polymeric stabilisation foil (27) of the photovoltaic label (3) forms a positive substance jointing for attaching the photovoltaic label (3) to the front side surface (9) of the carrier substrate (5).

7. Car body panel according to claim 5, wherein the carrier substrate (5) comprises at least one depression (45) at its front side surface (9) within the recess area (7), wherein the depression (45) is filled with a glue (51) for attaching the photovoltaic label (3) to the front side surface (9) of the carrier substrate (5) and wherein the photovoltaic label (3) directly abuts to the front side surface (9) of the carrier substrate (5) in partial areas of the recess area (7) laterally adjacent to the depression (45).

8. Car body panel according to one of the preceding claims, wherein the carrier substrate (5) comprises at least one through hole (37, 49) within the recess area (7), the through hole (37, 49) connecting a front side of the carrier substrate (5) within the recess area (7) with a rear side of the carrier substrate (5).

9. Car body panel according to one of the preceding claims, wherein the carrier substrate (5) comprises a polymer material, optionally reinforced with at least one of metal particles and glass particles.

10. Car body panel according to one of the preceding claims, wherein the carrier substrate (5) is formed by one of 3D printing, injection molding and thermoforming.

11. Method for fabricating a car body panel (1), comprising:
- providing a photovoltaic label (3), a carrier substrate (5) and a cover foil (39),
wherein the photovoltaic label (3) comprises a front side polymeric stabilisation foil (21), a front side polymeric lamination foil (23), a rear side polymeric lamination foil (25) and, optionally, a rear side polymeric stabilisation foil (27) and wherein the photovoltaic label (3) further comprises a solar cell arrangement (29) interposed between both lamination foils (23, 25),
wherein the carrier substrate (5) comprises a recess area (7) in which an outer surface (9) of the carrier substrate (5) is depressed in comparison to an outer surface (11) in an area (13) adjacent to the recess area (7), and
wherein the cover foil (39) comprises an opaque area (41);
- accommodating the photovoltaic label (3) within the recess area (7), wherein lateral dimensions of the recess area (7) and of the photovoltaic label (3) are set such that a gap (19) extends between an outer lateral circumference (18) of the photovoltaic label (3) and an outer lateral circumference (17) of the recess area (7); and
- arranging the cover foil (39) at an outer surface of the car body panel (1) such that its opaque area (41) covers the gap (19) as well as at least part of the outer surface (11) of the carrier substrate (5) in the area (13) adjacent to the recess area (7).

12. Method according to claim 11, further comprising:
- attaching the photovoltaic label (3) with its rear side to a front side surface of the carrier substrate (5) within the recess area (7), and
wherein, optionally, the outer surface (9) of the carrier substrate (5) in the recess area (7) is non-planar and wherein, upon attaching the photovoltaic label (3) to the carrier substrate (5), the photovoltaic label (3) is deformed such as to conform to the non-planar outer surface (9) of the carrier substrate (5) in the recess area (7).

13. Method according to one of claim 12, wherein the photovoltaic label (3) is laminated onto the carrier substrate (5) such that one of the rear side polymeric lamination foil (25) and the rear side polymeric stabilisation foil (27) of the photovoltaic label (3) forms a positive substance jointing for attaching the photovoltaic label (3) to the front side surface (9) of the carrier substrate ( 5).

14. Method according to one of claim 12, wherein the carrier substrate (5) comprises at least one depression (45) at its front side surface (9) within the recess area, the method further comprising:
- filling the depression (45) with a glue (51) for attaching the photovoltaic label (3) to the front side surface (9) of the carrier substrate (5), wherein, upon being accommodated within the recess area (7), the photovoltaic label (3) directly abuts to the front side surface (9) of the carrier substrate (5) in partial areas of the recess area (7) laterally adjacent to the depression (45).

15. Method according to one of claim 12, further comprising:
- providing a lamination bag (53) comprising a front side bag foil (55) and a rear side bag foil (57) enclosing an inner volume (59);
- introducing the carrier substrate (5) with the photovoltaic label (3) being accommodated in the recess area (7) into the inner volume (59) of the lamination bag (53), and
- laminating the front side bag foil (55) and the rear side bag foil (57) onto opposite outer surfaces of the carrier substrate (5), respectively, such as to enclose the carrier substrate (5) with the photovoltaic label (3) being accommodated in the recess area (7) from both opposing sides between the bag foils (55, 57) of the lamination bag (53), and
wherein, optionally, the cover foil (39) is formed by a portion of the front side bag foil (55).

## Patentansprüche

1. Karosserie-Paneel (1), aufweisend:
ein Photovoltaik-Label (3), und
ein Trägersubstrat (5),
wobei das Photovoltaik-Label (3) eine vorderseitige Polymer-Stabilisationsfolie (21), eine vorderseitige Polymer-Laminationsfolie (23), eine rückseitige Polymer-Laminationsfolie (25) und optional eine rückseitige Polymer-Stabilisationsfolie (27) aufweist, und wobei das Photovoltaik-Label (3) ferner eine Solarzellenanordnung (29) aufweist, die zwischen den beiden Laminationsfolien (23, 25) angeordnet ist,
wobei das Trägersubstrat (5) einen Vertiefungsbereich (7) aufweist, in dem eine Außenfläche (9) des Trägersubstrats (5) im Vergleich zu einer Außenfläche (11) in einem an den Vertiefungsbereich (7) angrenzenden Bereich (13) vertieft ist,
wobei das Photovoltaik-Label (3) innerhalb des Vertiefungsbereichs (7) untergebracht ist, wobei seitliche Abmessungen des Vertiefungsbereichs (7) und des Photovoltaik-Labels (3) so eingestellt sind, dass ein Spalt (19) zwischen einem äußeren seitlichen Umfang (18) des Photovoltaik-Labels (3) und einem äußeren seitlichen Umfang (17) des Vertiefungsbereichs (7) verläuft,
**dadurch gekennzeichnet, dass**
das Karosserie-Paneel ferner eine Abdeckfolie (39) aufweist,
wobei die Abdeckfolie (39) einen opaken Bereich (41) aufweist, und
wobei die Abdeckfolie (39) an einer Außenfläche des Karosserie-Paneels (1) so angeordnet ist, dass ihr opaker Bereich (41) den Spalt (19) sowie zumindest einen Teil der Außenfläche (11) des Trägersubstrats (5) in dem an den Vertiefungsbereich (7) angrenzenden Bereich (13) abdeckt.

2. Karosserie-Paneel nach Anspruch 1,
wobei der Spalt (19) eine Breite von mindestens 1 mm aufweist und/oder
wobei der Spalt (19) zumindest teilweise mit einer Spachtelmasse (33) ausgefüllt ist, und/oder
wobei die Abdeckfolie (39) eine selbstklebende Folie ist.

3. Karosserie-Paneel nach einem der vorhergehenden Ansprüche, ferner aufweisend eine Beschichtungsschicht (43), die eine äußerste Schicht an der Außenfläche des Karosserie-Paneels (1) zumindest in einem Bereich oberhalb des Photovoltaik-Labels (3) und vorzugsweise oberhalb des Spalts (19) bildet, und
wobei optional die Beschichtungsschicht (43) eine höhere Kratzfestigkeit aufweist als die Abdeckfolie (39).

4. Karosserie-Paneel nach einem der vorhergehenden Ansprüche, wobei die Abdeckfolie (39) weiterhin einen transparenten Bereich (42) aufweist und wobei die Abdeckfolie (39) so angeordnet ist, dass ihr transparenter Bereich (42) auf der Solarzellenanordnung (29) des Photovoltaik-Labels (3) liegt.

5. Karosserie-Paneel nach einem der vorhergehenden Ansprüche, wobei das Photovoltaik-Label (3) mit seiner Rückseite an einer Vorderseitenfläche des Trägersubstrats (5) innerhalb des Vertiefungsbereichs (7) angebracht ist.

6. Karosserie-Paneel nach Anspruch 5, wobei eine der rückseitigen Polymer-Laminationsfolie (25) und der rückseitigen Polymer-Stabilisationsfolie (27) des Photovoltaik-Labels (3) eine stoffschlüssige Verbindung zur Befestigung des Photovoltaik-Labels (3) an der Vorderseitenfläche (9) des Trägersubstrats (5) bildet.

7. Karosserie-Paneel nach Anspruch 5, wobei das Trägersubstrat (5) an seiner Vorderseitenfläche (9) innerhalb des Vertiefungsbereiches (7) mindestens eine Vertiefung (45) aufweist, wobei die Vertiefung (45) mit einem Klebstoff (51) zur Befestigung des Photovoltaik-Labels (3) an der Vorderseitenfläche (9) des Trägersubstrats (5) gefüllt ist und wobei das Photovoltaik-Label (3) in Teilbereichen des Vertiefungsbereiches (7) seitlich neben der Vertiefung (45) direkt an der Vorderseitenfläche (9) des Trägersubstrats (5) anliegt.

8. Karosserie-Paneel nach einem der vorhergehenden Ansprüche, wobei das Trägersubstrat (5) innerhalb des Vertiefungsbereichs (7) mindestens ein Durchgangsloch (37, 49) aufweist, wobei das Durchgangsloch (37, 49) eine Vorderseite des Trägersubstrats (5) innerhalb des Vertiefungsbereichs (7) mit einer Rückseite des Trägersubstrats (5) verbindet.

9. Karosserie-Paneel nach einem der vorhergehenden Ansprüche, wobei das Trägersubstrat (5) ein Polymermaterial aufweist, das optional mit mindestens einem von Metallpartikeln und Glaspartikeln verstärkt ist.

10. Karosserie-Paneel nach einem der vorhergehenden Ansprüche, wobei das Trägersubstrat (5) durch eines der folgenden Verfahren hergestellt wird: 3D-Druck, Spritzgießen oder Thermoformen.

11. Verfahren zum Herstellen eines Karosserie-Paneels (1), aufweisend:
- Bereitstellen eines Photovoltaik-Labels (3), eines Trägersubstrats (5) und einer Abdeckfolie (39),
wobei das Photovoltaik-Label (3) eine vorderseitige Polymer-Stabilisationsfolie (21), eine vorderseitige Polymer-Laminationsfolie (23), eine rückseitige Polymer-Laminationsfolie (25) und optional eine rückseitige Polymer-Stabilisationsfolie (27) aufweist und wobei das Photovoltaik-Label (3) weiterhin eine Solarzellenanordnung (29) aufweist, die zwischen den beiden Laminationsfolien (23, 25) angeordnet ist,
wobei das Trägersubstrat (5) einen Vertiefungsbereich (7) aufweist, in dem eine Außenfläche (9) des Trägersubstrats (5) im Vergleich zu einer Außenfläche (11) in einem an den Vertiefungsbereich (7) angrenzenden Bereich (13) vertieft ist, und
wobei die Abdeckfolie (39) einen opaken Bereich (41) aufweist;
- Aufnehmen des Photovoltaik-Labels (3) innerhalb des Vertiefungsbereichs (7), wobei seitliche Abmessungen des Vertiefungsbereichs (7) und des Photovoltaik-Labels (3) so eingestellt sind, dass sich ein Spalt (19) zwischen einem äußeren seitlichen Umfang (18) des Photovoltaik-Labels (3) und einem äußeren seitlichen Umfang (17) des Vertiefungsbereichs (7) erstreckt; und
- Anordnen der Abdeckfolie (39) an einer Außenfläche des Karosserie-Paneels (1), so dass ihr opaker Bereich (41) den Spalt (19) sowie zumindest einen Teil der Außenfläche (11) des Trägersubstrats (5) in dem an den Vertiefungsbereich (7) angrenzenden Bereich (13) abdeckt.

12. Verfahren nach Anspruch 11, ferner aufweisend:
- Anbringen des Photovoltaik-Labels (3) mit seiner Rückseite an einer Vorderseitenfläche des Trägersubstrats (5) innerhalb des Vertiefungsbereichs (7), und
wobei optional die Außenfläche (9) des Trägersubstrats (5) in dem Vertiefungsbereich (7) nicht eben ist und wobei beim Anbringen des Photovoltaik-Labels (3) an dem Trägersubstrat (5) das Photovoltaik-Label (3) so verformt wird, dass es sich an die nicht ebene Außenfläche (9) des Trägersubstrats (5) in dem Vertiefungsbereich (7) anpasst.

13. Verfahren nach einem der Ansprüche 12, wobei das Photovoltaik-Label (3) so auf das Trägersubstrat (5) auflaminiert wird, dass eine der rückseitigen Polymer-Laminationsfolie (25) und der rückseitigen Polymer-Stabilisationsfolie (27) des Photovoltaik-Labels (3) eine stoffschlüssige Verbindung zur Befestigung des Photovoltaik-Labels (3) an der Vorderseitenfläche (9) des Trägersubstrats (5) bildet.

14. Verfahren nach einem der Ansprüche 12, wobei das Trägersubstrat (5) mindestens eine Vertiefung (45) an seiner Vorderseitenfläche (9) innerhalb des Vertiefungsbereiches aufweist, wobei das Verfahren ferner aufweist:
- Füllen der Vertiefung (45) mit einem Klebstoff (51) zum Befestigen des Photovoltaik-Labels (3) an der Vorderseitenfläche (9) des Trägersubstrats (5), wobei das Photovoltaik-Label (3) bei Aufnahme in den Vertiefungsbereich (7) in Teilbereichen des Vertiefungsbereichs (7) seitlich neben der Vertiefung (45) direkt an der Vorderseitenfläche (9) des Trägersubstrats (5) anliegt.

15. Verfahren nach einem der Ansprüche 12, ferner aufweisend:
- Bereitstellen eines Laminierbeutels (53), der eine vorderseitige Beutelfolie (55) und eine rückseitige Beutelfolie (57) aufweist, die ein Innenvolumen (59) einschließen;
- Einführen des Trägersubstrats (5) mit dem Photovoltaik-Label (3), das im Vertiefungsbereich (7) untergebracht ist, in das Innenvolumen (59) des Laminierbeutels (53), und
- Laminieren der vorderseitigen Beutelfolie (55) und der rückseitigen Beutelfolie (57) auf jeweils gegenüberliegende Außenflächen des Trägersubstrats (5), so dass das Trägersubstrat (5) mit dem im Vertiefungsbereich (7) untergebrachten Photovoltaik-Label (3) von beiden gegenüberliegenden Seiten zwischen den Beutelfolien (55, 57) des Laminierbeutels (53) eingeschlossen wird, und
wobei optional die Abdeckfolie (39) durch einen Teil der vorderseitigen Beutelfolie (55) gebildet wird.

## Revendications

1. Panneau de carrosserie de voiture (1) comprenant :
une étiquette photovoltaïque (3), et
un substrat de support (5),
dans lequel l'étiquette photovoltaïque (3) comprend une feuille de stabilisation polymère côté avant (21), une feuille de laminage polymère côté avant (23), une feuille de laminage polymère côté arrière (25) et, en option, une feuille de stabilisation polymère côté arrière (27), et dans lequel l'étiquette photovoltaïque (3) comprend en outre un agencement de cellules solaires (29) interposé entre les deux feuilles de laminage (23, 25),
dans lequel le substrat de support (5) comprend une zone de retrait (7) dans laquelle une surface extérieure (9) du substrat de support (5) est enfoncée par rapport à une surface extérieure (11) dans une zone (13) adjacente à la zone de retrait (7),
dans lequel l'étiquette photovoltaïque (3) est logée dans la zone de retrait (7), les dimensions latérales de la zone de retrait (7) et de l'étiquette photovoltaïque (3) étant définies de telle sorte qu'un espace (19) s'étende entre une circonférence latérale extérieure (18) de l'étiquette photovoltaïque (3) et une circonférence latérale extérieure (17) de la zone de retrait (7),
**caractérisé en ce que**
le panneau de carrosserie de voiture comprend en outre une feuille de couverture (39),
dans lequel la feuille de couverture (39) comprend une zone opaque (41), et
dans lequel la feuille de couverture (39) est disposée sur une surface extérieure du panneau de carrosserie de voiture (1) de telle sorte que sa zone opaque (41) couvre l'espace (19) ainsi qu'au moins une partie de la surface extérieure (11) du substrat de support (5) dans la zone (13) adjacente à la zone de retrait (7).

2. Panneau de carrosserie de voiture selon la revendication 1,
dans lequel l'espace (19) a une largeur d'au moins 1 mm et/ou
dans lequel l'espace (19) est au moins partiellement rempli avec un mastic (33), et/ou
dans lequel la feuille de couverture (39) est une feuille auto-adhésive.

3. Panneau de carrosserie de voiture selon l'une des revendications précédentes, comprenant en outre une couche de revêtement (43) formant une couche la plus extérieure sur la surface extérieure du panneau de carrosserie de voiture (1) au moins dans une zone située au-dessus de l'étiquette photovoltaïque (3) et, de préférence, au-dessus de l'espace (19), et
dans lequel, en option, la couche de revêtement (43) présente une résistance à la rayure supérieure à celle de la feuille de couverture (39).

4. Panneau de carrosserie de voiture selon l'une des revendications précédentes, dans lequel la feuille de couverture (39) comprend en outre une zone transparente (42) et dans lequel la feuille de couverture (39) est disposée de manière à ce que sa zone transparente (42) soit placée au-dessus de l'agencement de cellules solaires (29) de l'étiquette photovoltaïque (3).

5. Panneau de carrosserie de voiture selon l'une des revendications précédentes, dans lequel l'étiquette photovoltaïque (3) est fixée par son côté arrière à une surface côté avant du substrat de support (5) dans la zone de retrait (7).

6. Panneau de carrosserie de voiture selon la revendication 5, dans lequel une de la feuille de laminage polymère côté arrière (25) et de la feuille de stabilisation polymère côté arrière (27) de l'étiquette photovoltaïque (3) forme une liaison par coopération de matières pour fixer l'étiquette photovoltaïque (3) à la surface côté avant (9) du substrat de support (5).

7. Panneau de carrosserie de voiture selon la revendication 5, dans lequel le substrat de support (5) comprend au moins une dépression (45) sur sa surface côté avant (9) dans la zone de retrait (7), dans lequel la dépression (45) est remplie avec une colle (51) pour fixer l'étiquette photovoltaïque (3) à la surface côté avant (9) du substrat de support (5) et dans lequel l'étiquette photovoltaïque (3) est directement en contact avec la surface côté avant (9) du substrat de support (5) dans des zones partielles de la zone de retrait (7) latéralement adjacentes à la dépression (45).

8. Panneau de carrosserie de voiture selon l'une des revendications précédentes, dans lequel le substrat de support (5) comprend au moins un trou traversant (37, 49) dans la zone de retrait (7), le trou traversant (37, 49) reliant un côté avant du substrat de support (5) dans la zone de retrait (7) à un côté arrière du substrat de support (5) .

9. Panneau de carrosserie de voiture selon l'une des revendications précédentes, dans lequel le substrat de support (5) comprend un matériau polymère, en option renforcé par des particules de métal et/ou des particules de verre.

10. Panneau de carrosserie de voiture selon l'une des revendications précédentes, dans lequel le substrat de support (5) est formé par l'un des procédés suivante : impression 3D, moulage par injection et thermoformage.

11. Procédé de fabrication d'un panneau de carrosserie de voiture (1), consistant à :
- fournir une étiquette photovoltaïque (3), un substrat de support (5) et une feuille de couverture (39),
dans lequel l'étiquette photovoltaïque (3) comprend une feuille de stabilisation polymère côté avant (21), une feuille de laminage polymère côté avant (23), une feuille de laminage polymère côté arrière (25) et, en option, une feuille de stabilisation polymère côté arrière (27), et dans lequel l'étiquette photovoltaïque (3) comprend en outre un agencement de cellules solaires (29) interposé entre les deux feuilles de laminage (23, 25),
dans lequel le substrat de support (5) comprend une zone de retrait (7) dans laquelle une surface extérieure (9) du substrat de support (5) est enfoncée par rapport à une surface extérieure (11) dans une zone (13) adjacente à la zone de retrait (7), et
dans lequel la feuille de couverture (39) comprend une zone opaque (41) ;
- loger l'étiquette photovoltaïque (3) dans la zone de retrait (7), des dimensions latérales de la zone de retrait (7) et de l'étiquette photovoltaïque (3) étant définies de telle sorte qu'un espace (19) s'étende entre une circonférence latérale extérieure (18) de l'étiquette photovoltaïque (3) et une circonférence latérale extérieure (17) de la zone de retrait (7) ; et
- disposer la feuille de couverture (39) sur une surface extérieure du panneau de carrosserie de voiture (1) de telle sorte que sa zone opaque (41) couvre l'espace (19) ainsi qu'au moins une partie de la surface extérieure (11) du substrat de support (5) dans la zone (13) adjacente à la zone de retrait (7).

12. Procédé selon la revendication 11, consistant en outre à :
- fixer l'étiquette photovoltaïque (3) par son côté arrière à une surface côté avant du substrat de support (5) dans la zone de retrait (7), et
dans lequel, en option, la surface extérieure (9) du substrat de support (5) dans la zone de retrait (7) n'est pas plane et dans lequel, lors de la fixation de l'étiquette photovoltaïque (3) au substrat de support (5), l'étiquette photovoltaïque (3) est déformée de manière à se conformer à la surface extérieure non plane (9) du substrat de support (5) dans la zone de retrait (7).

13. Procédé selon la revendication 12, dans lequel l'étiquette photovoltaïque (3) est laminée sur le substrat de support (5) de telle sorte que l'une de la feuille de laminage polymère côté arrière (25) et de la feuille de stabilisation polymère côté arrière (27) de l'étiquette photovoltaïque (3) forme une liaison par coopération de matières pour fixer l'étiquette photovoltaïque (3) à la surface côté avant (9) du substrat de support (5).

14. Procédé selon la revendication 12, dans lequel le substrat de support (5) comprend au moins une dépression (45) sur sa surface côté avant (9) dans la zone de retrait, le procédé consistant en outre à :
- remplir la dépression (45) avec une colle (51) pour fixer l'étiquette photovoltaïque (3) à la surface côté avant (9) du substrat de support (5), dans lequel, lorsqu'elle est logée dans la zone de retrait (7), l'étiquette photovoltaïque (3) est directement en contact avec la surface côté avant (9) du substrat de support (5) dans des zones partielles de la zone de retrait (7) latéralement adjacentes à la dépression (45) .

15. Procédé selon la revendication 12, consistant en outre à :
- fournir un sac de laminage (53) comprenant une feuille de sac côté avant (55) et une feuille de sac côté arrière (57) enfermant un volume intérieur (59) ;
- introduire le substrat de support (5) avec l'étiquette photovoltaïque (3) logée dans la zone de retrait (7) dans le volume intérieur (59) du sac de laminage (53), et
- laminer la feuille de sac côté avant (55) et la feuille de sac côté arrière (57) sur des surfaces extérieures opposées du substrat de support (5), respectivement, de manière à enfermer le substrat de support (5) avec l'étiquette photovoltaïque (3) logée dans la zone de retrait (7) à partir des deux côtés opposés entre les feuilles de sac (55, 57) du sac de laminage (53), et
dans lequel, en option, la feuille de couverture (39) est formée par une partie de la feuille de sac côté avant (55).
